Europäisches Patentamt

European Patent Office

Office européen des brevets

(19)

(11) EP 1 380 972 A2

(12) **EUROPEAN PATENT APPLICATION**

(43) Date of publication:
**14.01.2004 Bulletin 2004/03**

(51) Int Cl.⁷: **G06F 17/50**, G01M 17/02, B60C 19/00

(21) Application number: **03015817.4**

(22) Date of filing: **10.07.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **12.07.2002 JP 2002204669**
**12.07.2002 JP 2002204670**

(71) Applicant: **Sumitomo Rubber Industries Ltd.**
**Kobe-shi, Hyogo-ken (JP)**

(72) Inventors:
• **Miyori, Akio**
**3-chome, Chuo-ku, Kobe-shi, Hyogo-ken (JP)**
• **Shiraishi, Masaki**
**3-chome, Chuo-ku, Kobe-shi, Hyogo-ken (JP)**
• **Iwasaki, Naoaki**
**3-chome, Chuo-ku, Kobe-shi, Hyogo-ken (JP)**

(74) Representative:
**Manitz, Finsterwald & Partner GbR**
**Postfach 31 02 20**
**80102 München (DE)**

(54) **Method of simulating tire and snow**

(57)    A method of simulating a tire on snow comprises

making a model of the tire made up of numerically analyzable elements,

making a model of the snow made up of numerically analyzable elements being capable of presenting its volume change caused by compression and being capable of maintaining a volume change after the compression is removed,

repeating: setting of conditions for rolling the tire model and contacting the tire model with the snow model; computing of deformation of the tire model; and computing of deformation of the snow model, at minute time intervals to obtain at least one of the following data: a force produced on the tire model in the back and forth direction; mass density, pressure, stress and velocity of the snow model; and contact force between the tire model and snow model, and

outputting the above-mentioned at least one of the data.

**FIG.1**

```
        ┌─────────────────────┐
        │   Simulating Tire   │
        └─────────────────────┘
                  │
        ┌─────────────────────┐
        │ Make Tire model and │
        │     Road mode       │
        └─────────────────────┘
                  │
        ┌─────────────────────┐
        │ Set Boundary        │
        │   conditions        │
        └─────────────────────┘
                  │
        ┌──────────────────────────┐
        │ Compute Deformation of   │
        │ Tire model and Road      │
        │ model after minute time  │
        └──────────────────────────┘
                  │
        ┌──────────────────────────┐
        │ Couple Tire model and    │
        │ Road model with each     │
        │ other                    │
        └──────────────────────────┘
                  │
             ╱─────────╲
            ╱ Repetition ╲  No (Repeat)
            ╲  end ?     ╱────────┐
             ╲─────────╱          │
                  │ YES
        ┌─────────────────────┐
        │ Output Data for     │
        │   evaluation        │
        └─────────────────────┘
                  │
        ┌─────────────────────┐
        │  End of Simulation  │
        └─────────────────────┘
```

EP 1 380 972 A2

**EP 1 380 972 A2**

**Description**

The present invention relates to a method of simulating a tire on the snowy roads being capable of estimating tire performance, behavior and the like.

Conventionally, development of a tire is a repetitive task which requires much time and cost, namely, making a prototype, testing the prototype and improving it according the test results, and again making an improved prototype. These are continued until the requirements are satisfied. Accordingly, development efficiency is very low.

In recent years, therefore, in order to solve this problem, computer simulations incorporating a finite element method therein are utilized to estimate and analyze tire performance to develop a tire without making a large number of prototypes.

However, in case of a tire used on the snowy roads such as snow tire and studless tire, as the simulation of a tire on the snow was not able to be carried out until now, many actual vehicle tests are needed in order to improve on-the-snow performance of the tire. Thus, a significant increase in the development cost and period is inevitable in developing this kind of tires because it is difficult to make a snowy road artificially and a snow season when actual vehicle tests are possible is short.

It is therefore, an object of the present invention provide a method of simulating a tire and snow, by which various tire performance on the snowy roads can be well estimated.

According to the present invention, a method of simulating a tire on snow comprises

making a model of the tire made up of numerically analyzable elements,

making a model of the snow made up of numerically analyzable elements being capable of presenting its volume change caused by compression and being capable of maintaining a volume change after the compression is removed,

repeating: setting of conditions for rolling the tire model and contacting the tire model with the snow model; computing of deformation of the tire model; and computing of deformation of the snow model, at minute time intervals to obtain at least one of the following data: a force produced on the tire model in the back and forth direction; mass density, pressure, stress and velocity of the snow model; and contact force between the tire model and snow model, and

outputting the at least one of the data.

Embodiments of the present invention will now be described in detail in conjunction with the accompanying drawings.

Fig.1 is a flow chart showing a method of simulating a tire on snowy road according to the present invention.

Figs.2, 3 and 4 each show an example of the tire model.

Fig.5 shows a method of modeling fiber/cord reinforced rubber.

Fig.6 shows a method of simulating a tire mounted on a wheel rim.

Fig.7 shows an example of the material property given to the snow model.

Fig. 8 show an example of the snowy road model.

Figs.9 and 10 show deformation of a snow model.

Fig. 11 is a diagram for explaining compression of a snow model.

Figs.12, 13 and 14 are flow charts showing an embodiment of the present invention.

Fig.15 is a diagram for explaining a time increment.

Fig.16 is a diagram for explaining the pitch length of the mesh.

Fig.17 is a diagram for explaining a combination of the tire model and road model.

Fig.18 shows an example of the torque applied to the tire model.

Fig.19 is a graph for explaining the yield condition and crash condition of the snow model.

Fig.20 is a side view of the snow model for explaining a crashed Euler element.

Figs.21(a) and 21(b) are diagrams for explaining an experimental method for shearing a snow rod.

Fig.22 is a graph showing the experimental results of the shearing test.

Fig.23 shows a regression straight line showing the relationship between the vertical stress and the shearing stress at break down which was obtained from the experimental values.

Figs.24(a), 24(b), 24(c), 24(d) and 24(e) are diagrams for explaining Lagrange snow model.

Fig.25 is a graph showing a simulation result relating to a tire-traction force on snow.

Figs.26 and 27 are diagrams showing another example of the combination of the tire model and road model for explaining another way of defining the boundary conditions.

Figs.28 and 29 are simulation outputs which visualize a rutted snow where no tire skid occurs and a rutted snow where a skid occurs a little bit.

Fig.30 is a simulation output which visualizes a tire and rutted snow as a perspective view.

Fig. 31 is a simulation output which visualizes a rut on the snow as a perspective view, together with a ground pressure distribution.

Fig.32 shows an enlarged view similar to Fig.31 indicating the ground pressure distribution in a gray scale.

Fig.33 is a simulation output which visualizes a rut on the snow as a perspective view, together with a distribution of mass density of the trodden snow.

Fig.34 shows the same data as used in Fig.33 but in a different way such that the under part from a certain snow depth is hidden to improve the visibility of the snow compressed and pushed into tread grooves.

Fig.35 is a simulation output which visualizes a distribution of the shearing stress of the'snow model in a part contacting with the tire model.

Fig.36 is a diagram showing a simulation result where shear of snow rods packed into tread grooves occurs.

Fig.37(a) is a diagram for explaining the contact force of the snow element.

Fig.37(b) is a diagram for explaining the stress of the snow element.

Fig.38 shows a computer set for executing the simulation programs.

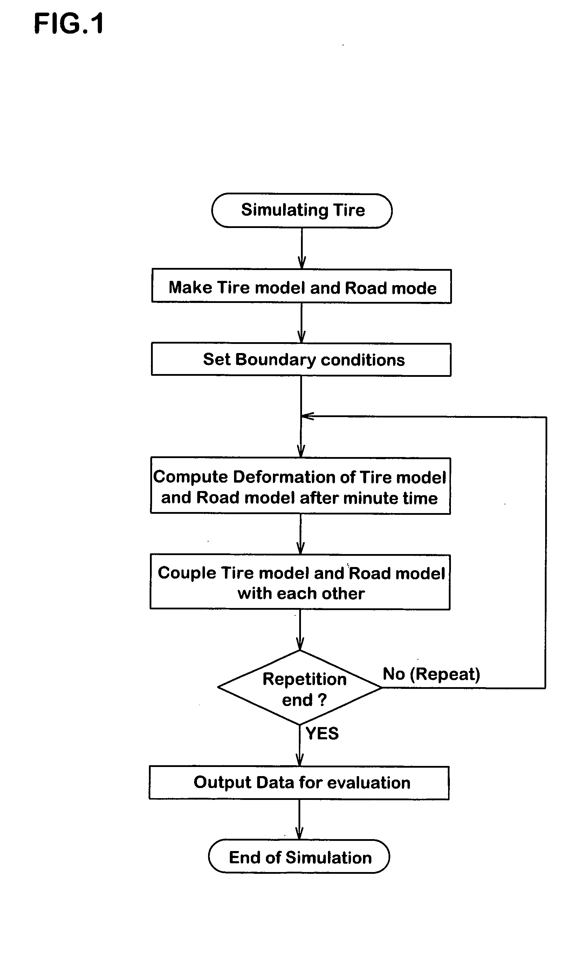

In Fig.1, a method of simulating a tire on a soft road according to the present invention is shown in generalities.

In the following embodiments, the tire and soft road to be simulated are a pneumatic tire and a snowy road.

As well known in the tire art, a pneumatic tire generally comprises a tread portion, a pair of axially spaced bead portions each with a bead core therein, a pair of sidewall portions extending between the tread edges and the bead portions, a carcass ply of cords extending between the bead portions, a tread reinforcing belt ply of cords disposed radially outside the carcass in the tread portion.

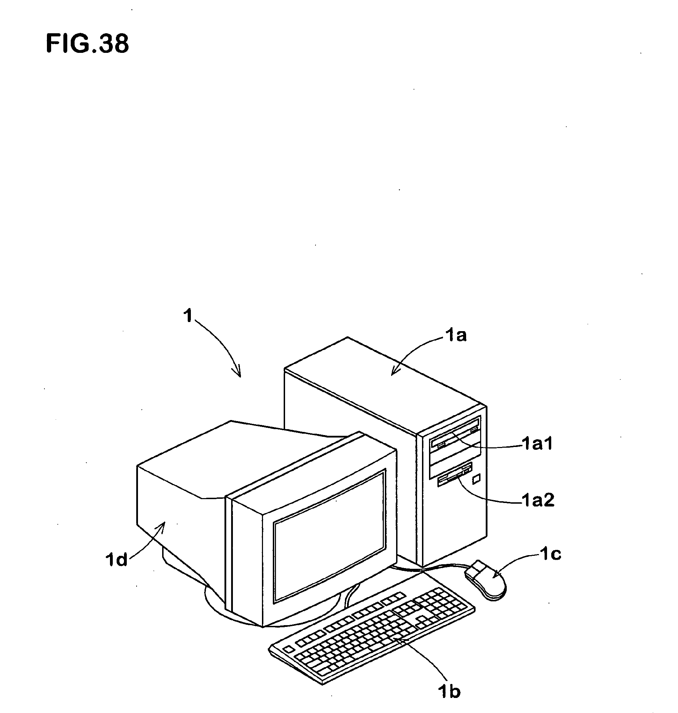

The simulation is carried out, using a general-purpose computer 1 as show in Fig.38 for example.

The computer 1 comprises a CPU corresponding to an arithmetic processing unit, a ROM in which a processing procedure of the CPU and the like are previously stored, a RAM corresponding to a processing memory of the CPU, an input and output port and a data bus connecting them. In this embodiment, the above-mentioned input and output port is connected with input devices I for inputting and setting information such as a key board, mouse and the like, outputting devices O capable of displaying input result and simulation result such as a display, printer and the like, and an external memory unit D such as a magnetic disc unit, magnetic optical disc unit and the like. The external memory device D can memorize processing procedure for simulation, other programs and data.

\* Making Tire Model and Road Model

In order to carry out a computer processing of a tire on a snowy road, a model of the tire and a model of the snowy road are made, using elements which are processable with a numerical-analysis method such as finite element method, finite volume method, finite difference method and boundary element method. In this embodiment, a finite element method (FEM) is employed for tire deformation and a finite volume method (FVM) for snow model.

\* Tire model

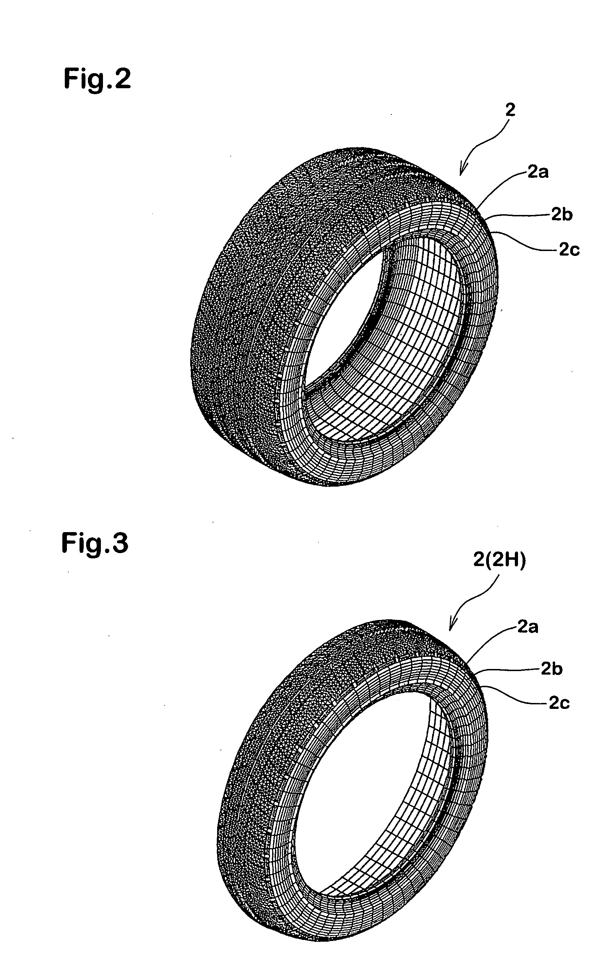

Fig.2 is a computer output showing a tire model 2 visualized in perspective.

The objective tire is divided into a number (finite number) of parts or elements 2a, 2b, 2c --.

For each element, its shape, the positions and number of node points and material properties such as mass density, Young's modulus and damping factor are determined, and the data thereof for example the coordinate values of the node points are given as numerical data to the computer 1.

In case of a relatively thick part, three-dimensional elements such as tetrahedral solid elements, pentahedral solid elements and hexahedral solid elements are used depending on the martial, position and the like of the object.

The tetrahedral solid elements may be preferably used to build up a complex three-dimensional shape as an aggregation of such elements.

For a relatively thin part which can be regarded as a two-dimensional part or plane, a quadrilateral element can be used.

\* Rubber material model

In case of the rubber components of the tire such as tread rubber and sidewall rubber, usually, three-dimensional solid elements are used. To the solid element, a definition of a superviscoelastic material is set.

\* Fiber/cord reinforced rubber model

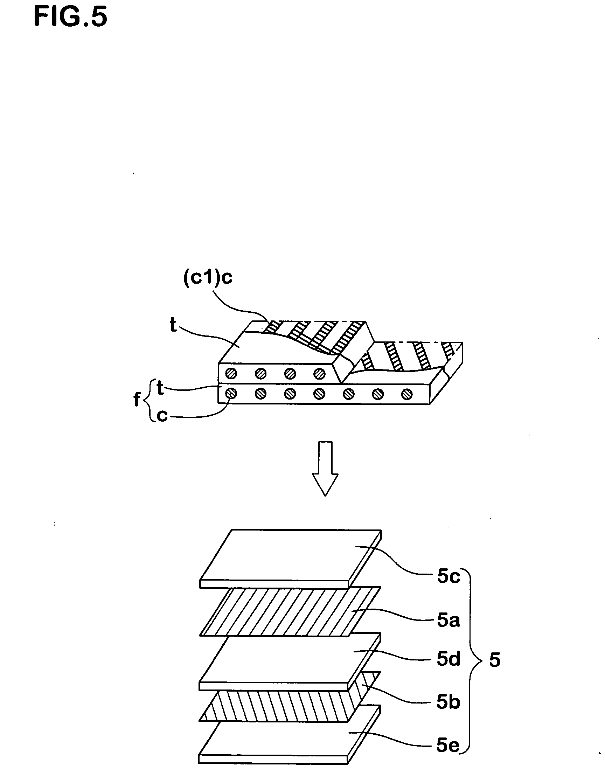

In case of tire components made up of a ply (c) of cords (c1) and a layer of topping rubber (t) on each side thereof such as carcass, tread belt and bead reinforcing layer, a solid element (5c-5e), e.g. hexahedral solid element is used for a topping rubber (t) layer, and a quadrilateral membrane element (5a, 5b) is used for a cord array (c). Thus, when the layer is made up two or more plies as shown in Fig.5, the model thereof is formed as a lamination of alternate solid elements (5c-5e) and quadrilateral membrane elements (5a, 5b).

To the quadrilateral membrane element, a thickness corresponding to the diameter of the cords (c1) is set, and a rigidity anisotropy where the modulus is high in the orienting direction of the cords (c1) but low in the orthogonal direction thereto, is set.

As to the solid elements for the rubber (topping rubber), these are treated as being made of a superviscoelastic material, and a definition of a superviscoelastic material is set to each solid element.

In Fig.2, as the tire has a tread pattern comprising tread elements such as blocks and ribs made of tread rubber divided by tread grooves, each tread element is defined one or more three-dimensional solid elements such as tetrahedral solid element and hexahedral solid element. Excluding the tread elements, a remaining part of the tire (hereinafter, the basal part) is almost homogeneous in the tire circumferential direction. Therefore, the basal part is preferably divided into relatively large-sized elements such as hexahedral solid elements in order to increase the computer resource. For example, the circumferential length of each elements is set in a range of less than 25 % of the circumferential length of the ground contacting patch. But in the axial direction, in order to reproduce the tread curvature accurately, the axial length of each element should be not more than 20 mm.

Fig.3 shows another example of the tire model 2, which is one half 2H of the above-mentioned tire model divided at the tire equator. when the tread pattern is symmetrical about the tire equator, such a halved tire model 2H may be useful to reduce the computer burden.

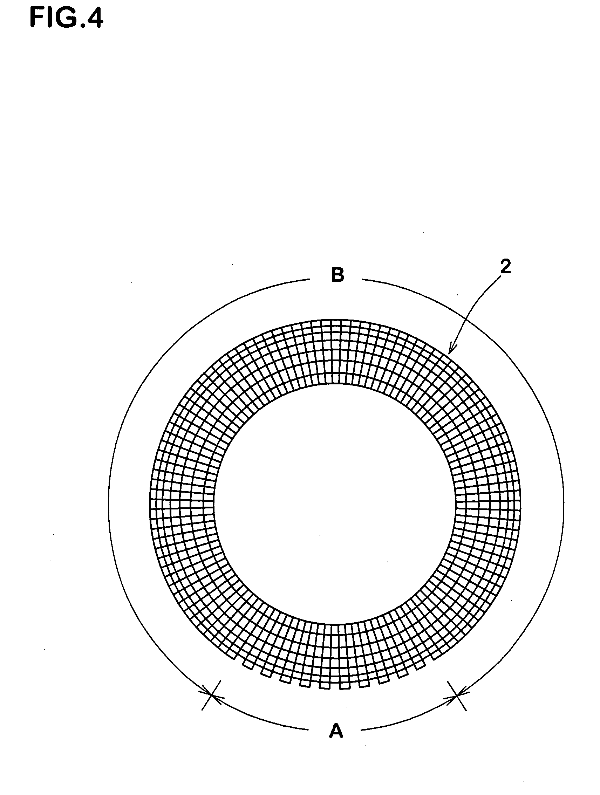

For example, when simulating the traction/braking performance of the tire, it is not always necessary for the tire to rotate a large angle around the tire axis. In such a case, a more simplified tire model as shown in Fig.4 may be used, wherein the ground contacting part (A) of the tread is faithfully modeled, but the remaining part (B) is roughly modeled or omitted.

In any case, it is possible that the raw data representing the tire not yet divided are prepared by converting the three-dimensional CAD data which can be obtained by drawing the objective tire three-dimensionally using a CAD system.

* simulation of Rim mounting

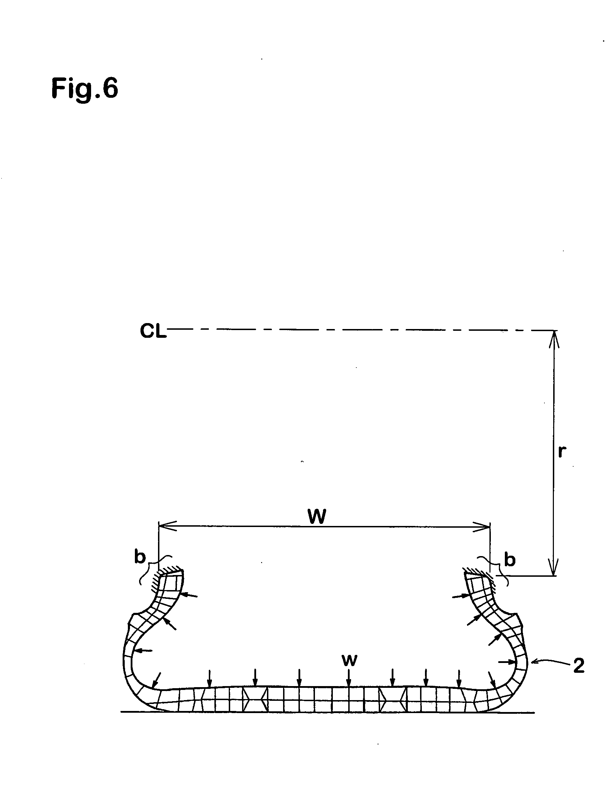

As shown in Fig.6, to simulate the tire mounted on a wheel rim, (1) the tire model 2 is put under restraint only in the parts (b) which contact with the wheel rim such that the bead width w of the tire model 2 becomes equal to the wheel rim width, and (2) the parts (b) are maintained at a constant radial distance (r) equal to the wheel rim diameter (r) from the rotational axis CL of the tire model 2.

* Simulation of Tire inflation

To simulate the tire inflated to a certain tire pressure, the inner surface of the tire model 2 facing the tire cavity is applied with an uniform load w corresponding to the pressure.

* Road model

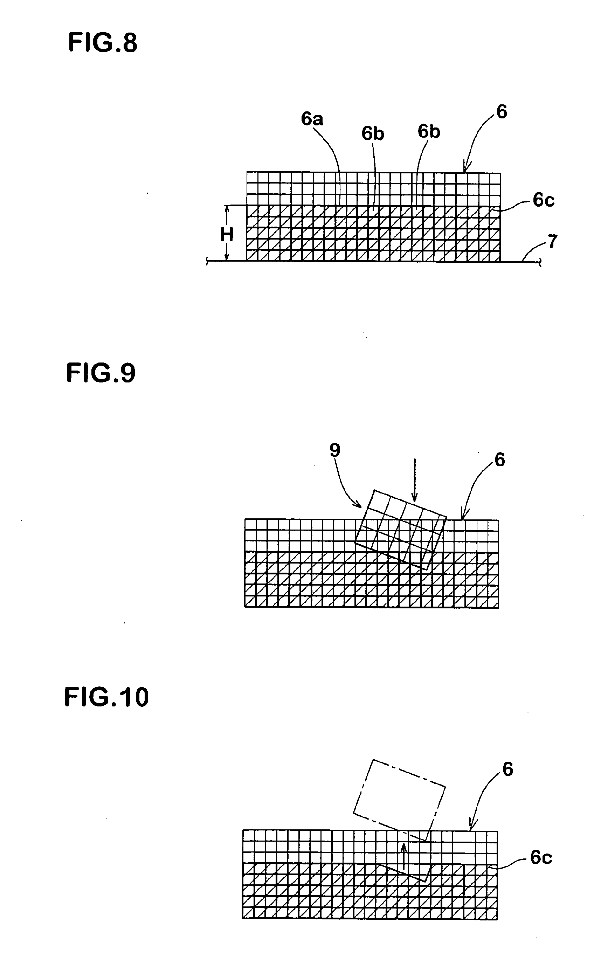

Fig.8 shows a cross sectional view of a model of a soft road taken along a vertical plane.
This snowy road model is made up of a model of a hard ground 7 and a model 6 of the snow on the ground 7.

* Ground model

The hard ground model is made up of a planar rigid element.

* Snow model

The snow model should be made, using such elements that when the volume is once decreased by compression (snow is once packed), the volume never turns back if freed from the compression.

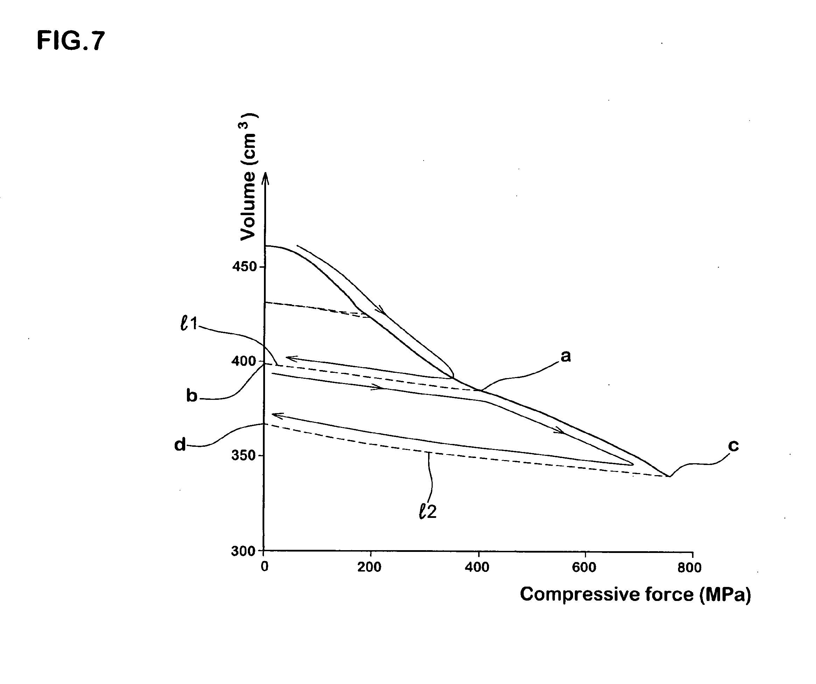

Fig.7 shows an example of hysteresis of the volume of the snow model when a compressive force (static pressure compression stress) is applied and then removed.
As indicated by a continuous line, during increasing in the compressive force, the volume decreases in proportion as to the increase in the compressive force, and accordingly the mass density increases.
But, when the applied compressive force is decreased from a certain point (a) on the continuous line, as indicated by a broken line (11), the volume does not fully turn back. only turning back is a part corresponding to the elastic strain which is very small in comparison with a part corresponding to the plastic strain. Thus, if the applied compressive force is completely removed (point b on the vertical axis), the deformed state remains permanently.
Further, when the compressive force is again increased, the volume decreases at a small rate, staring from the point (b) to the point (a), corresponding to the above-mentioned elastic strain. However, from the point (a), the volume decreases at a larger rate along the continuous line in proportion to the applied force. when the applied compressive force is decreased from a point (c) on the continuous line, a part corresponding to the elastic strain turns back as indicated by a broken line (12), and thus, even if the applied compressive force is completely removed (point d on the vertical axis), the more packed state remains permanently.

Incidentally, in Fig.7, the three broken lines (11, 12 --) are almost parallel with each other. This means that the modulus of volume elasticity is almost constant.

* Euler element

In this embodiment, hexahedral Euler elements which are processable in a finite volume method are used to make the snow model. Thus, the snow model 6 is made up of a virtual mesh 6a like a space lattice and fillers 6c. The lower end of the mesh is fixed to the ground model, and the mesh 6a partitions its occupied space into cubic spaces 6b. The fillers 6c fill up the respective cubic spaces 6b, and each of the fillers 6c is provided with a hysteresis property as shown in Fig.8. In other words, each snow element is made up of a cubic space 6b and a filler 6c. The total thickness H of the fillers 6c is set to a value corresponding to the depth of the snow on the ground.

In computing the deformation of the snow model 6,

when a part 9 of the tire model 2 (a tread rubber block) comes into contact with the snow model 6 as shown in Fig.9, the surface of the tread part 9 is treated and defined as a rigid wall, and fillers 6c whose positions correspond to those of the tread part 9 are eliminated, and the eliminated fillers 6c are treated as being pressed into the cubic spaces underside thereof.

Thus, as the fillers 6c on the outside of the surface of the tread block 9 remain although the fillers 6c on the inside of the surface of the tread block 9 are eliminated, as shown in Fig.10, when the tread block part 9 is took away from the snow model 6, the compressed shape is maintained due to the plastic volumetric strain.

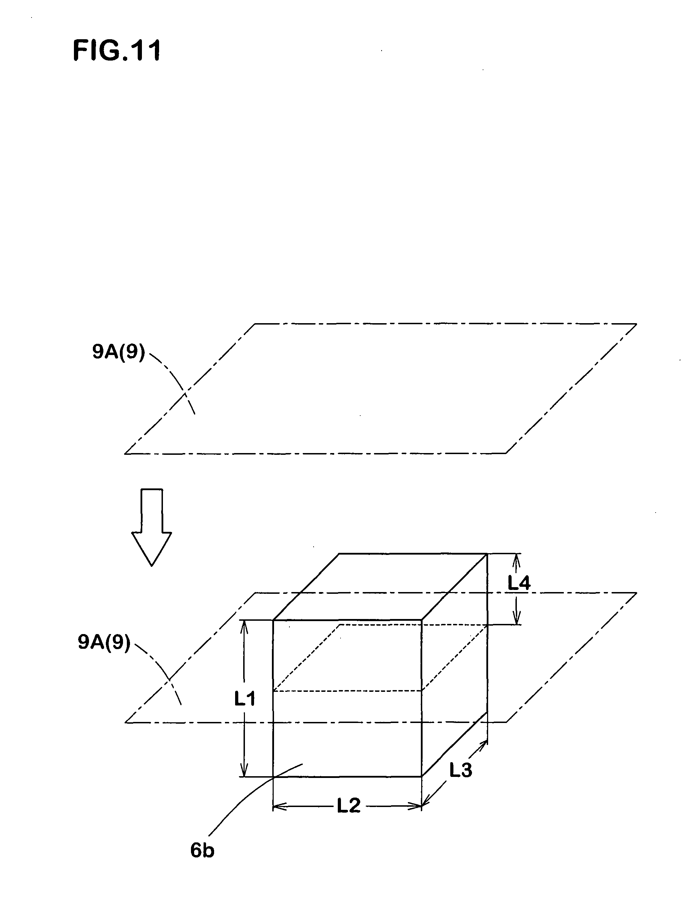

In the snow model 6 in the initial condition, one cubic space 6b is filled with a filler 6c having 100% of its volume V1 (=L1XL2XL3). As shown in Fig.11, when the surface 9A of the tread block of the tire model 2 enters into this cubic space and the volume V2 of the filler 6c becomes (L1-L4)XL2XL3, the volumetric strain of the filler 6c is given by the volume ratio (V2/V1).

Incidentally, the volumetric strain is the summation of an elastic volumetric strain which becomes zero when the stress is removed, and a plastic volumetric strain which maintains a positive value even when the stress is completely removed. Namely, as shown in Fig.10, when the tire model is took away from the snow model, only the plastic volumetric strain remains. In other words, the voluminal change is permanent.

When compared with Lagrange elements suitable for structural analysis, the use of Euler element is preferred because it can prevent the collapse of the mesh and a negative volume of the element which are liable to occur when the deformation becomes large and which make the computing unstable or impossible. This is however, not intended to limit the elements to Euler elements only.

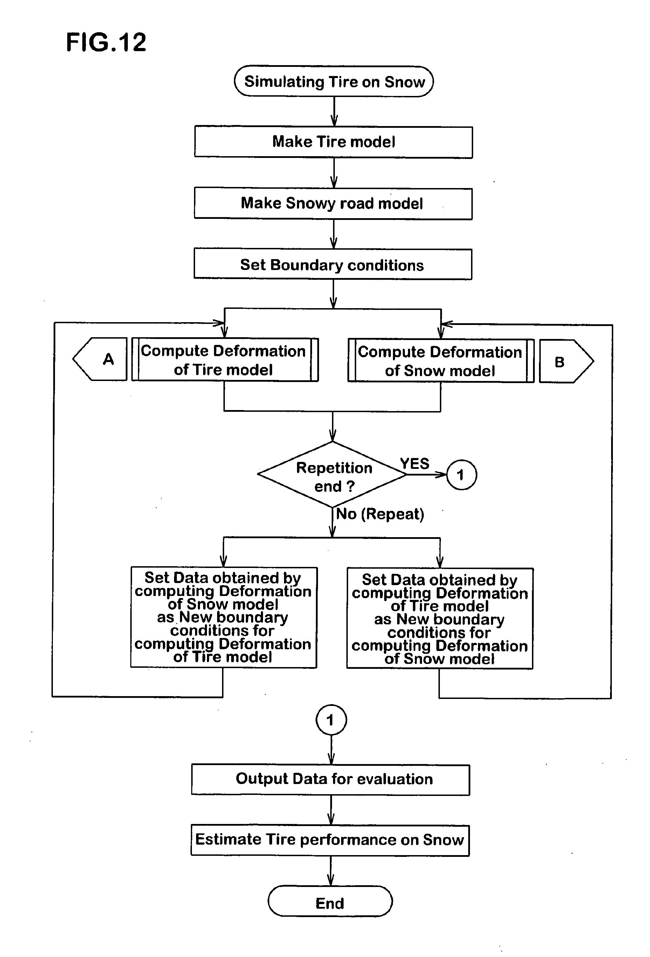

Figs.12, 13 and 14 show an example of procedures for simulating the tire on the snowy road according to the present invention. Such simulating procedures may be executed by the computer 1, utilizing a multi-purpose FEM and FVM analyzing software.

* Explicit method

In this example, an explicit method is used in computing the deformation of the model, namely, the deformation is computed per defined time increment without performing the computation of convergence. In order to stabilize the computation, the time increment is determined to satisfy the Courant condition. To be more precise, the time increment $\Delta t$ is initially set to satisfy the following condition.

$$\Delta t < Lmin/C$$

where

Lmin represents a length of the smallest element in the model, C is the propagation velocity of the stress wave in the object which can be obtained as the square root $\sqrt{E/\rho}$ of (Young's modulus E/Mass density $\rho$) in case of the first degree.

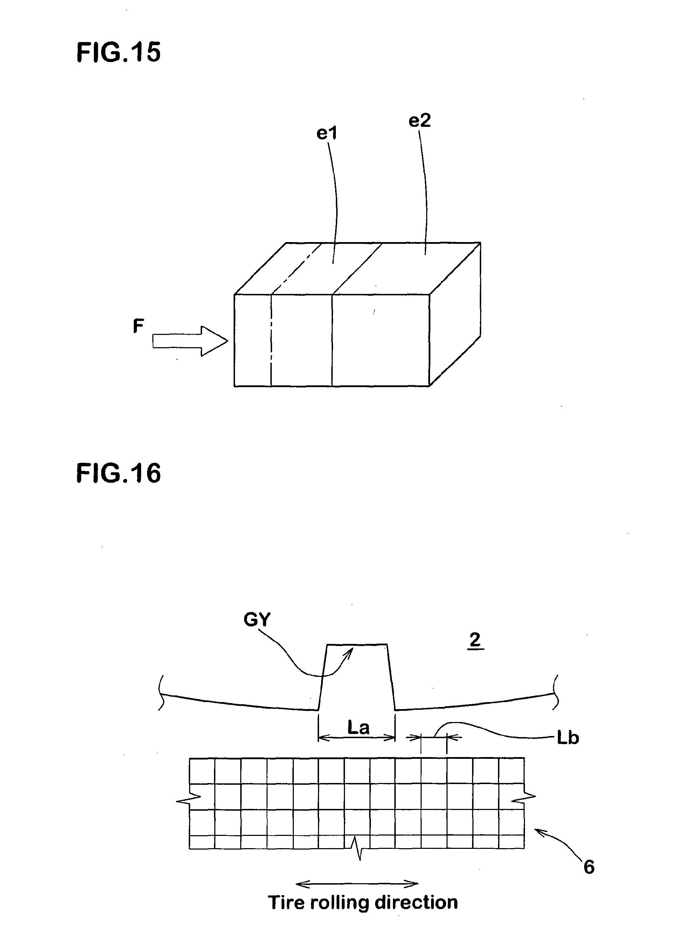

By setting the time increment as above, as shown in Fig.15, it becomes possible to compute the deformed state of an element e1 under such conditions that an external force F is applied to the elements e1 but not yet transmitted to the next elements e2.

In this embodiment, the stress wave transfer time is computed from the propagation velocity $\sqrt{E/\rho}$ of the stress wave and the size and mass density of the element.

The initial time increment in this example is set to the minimum value of the stress wave transfer time multiplied by a safety factor of more than 0.8 but less than 1.0.

More specifically, the initial time increment is set in a range of from 0.1 to 5 microseconds, more preferably 0.3 to 3 microseconds, still more preferably 0.5 to 2 microseconds in both of the tire model 2 and snow model 6.

In order to reduce the computation time, as shown in Fig.16, the pitch lengths Lb of the mesh (which are constant in this example), and the width La of the lateral tread grooves GY of the tire model 2, both in the traveling direction of the tire model, are limited to satisfy La >= Lb, preferably La > Lb, more preferably Lb >= La/2, but Lb > La/10.

* Setting Boundary conditions

Before starting the computing of deformation of the model, boundary conditions are set. For example, the above-mentioned conditions for mounting the tire model 2 on a wheel rim, the condition for inflating the tire model 2, a frictional coefficient between the tire model 2 and snow model 6, the modulus of volume elasticity of the snow model, the initial time increment and the like may be listed as the boundary conditions, and at least some of them are set.

* A Combination of Tire model and Snow model

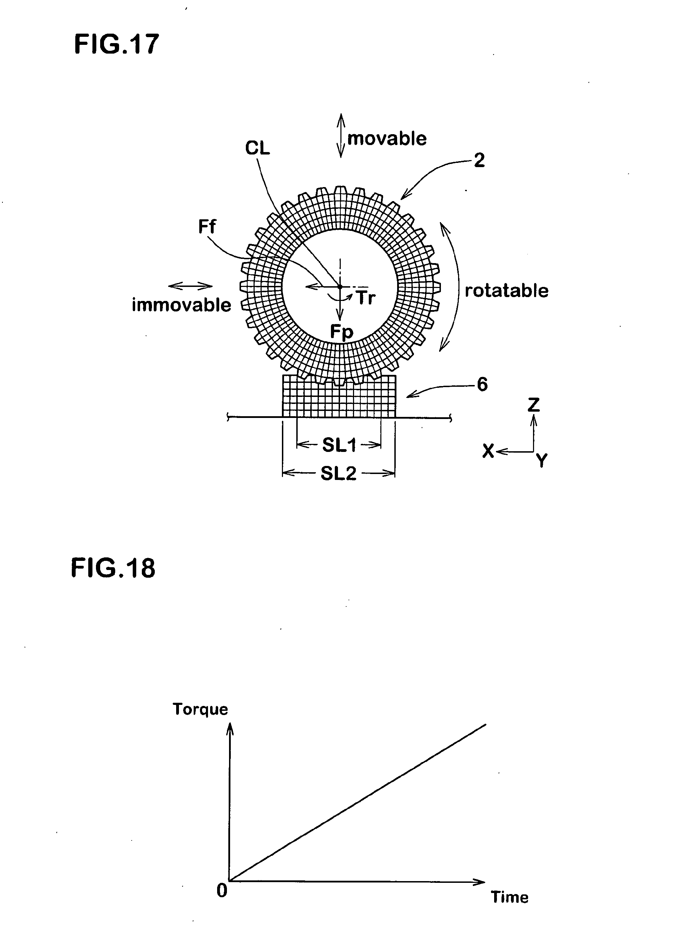

Fig. 17 shows an example of the combination of the tire model 2 and snow model 6. In this example, in a X-Y-Z coordinate system, the position of the snow model 6 is defined as being fixed, namely, immovable in the coordinate system, but the position of the tire rotational axis CL is defined as being movable only in the vertical direction, and the rotational axis CL is kept horizontal and the camber angle is zero degree.

In this example, therefore, the snow model 6 is not required to have a long length for rolling the tire model 2, in other words, the snow model 6 is made in a small size, which helps to decrease the computation time.

The length SL2 of the snow model 6 in the traveling direction of the tire model 2 can be decreased to less than 1.2 times, preferably and maybe less than 1.1 times but more than 1.0 times the circumferential length SL1 of the ground contacting patch of the tire model 2.

* Computing of Deformation of Models

The computing of deformation of the tire model 2 and the computing of deformation of the snow model 6 are carried out every time period corresponding to the above-mentioned time increment, while giving the rolling conditions. As a rolling condition, a vertical tire load Fp is applied to the rotational axis CL. In this example, further, in order to obtain simulation data relating to traction on snow, a torque Tr which continuously increases from zero with time is given to the rotational axis CL.

Besides, a translational motion speed of the tire, a rotational speed of the tire, an axial load or force applied to the tire, a slip angle of the tire and the like may be defined as rolling conditions.

In this embodiment, as shown in Fig.12, the computing of deformation of the tire model 2 and the computing of deformation of the snow model 6 are performed independently from each other. Then, the tire model 2 and the snow model 6 which have been independently computed for deformation are coupled by exchanging necessary data to carry out the computing of deformation in the next step.

More specifically, the data relating to the shape of the surface (especially contacting with the tire model 2), velocity and pressure of the snow model 6 obtained during computing the deformation of the snow model 6 are set as the boundary conditions for computing deformation of the tire model 2, and again the computing of deformation of the tire model 2 is performed.

On the other hand, the data relating to the shape of the surface (especially contacting with the snow model 6), and speed of the tire model 2 obtained during computing the deformation of the tire model 2 are set as the boundary conditions for computing deformation of the snow model 6 and again the computing of deformation of the snow model 6 is performed.

Through such coupling of the tire model and snow model, the positional change of the tire model 2, the resultant compressive force change and the like are reflected on the snow model 6 and a new deformation is caused. on the other hand, the surface shape of the snow model 6, the reactive force received from the snow model 6 and the like are reflected on the tire model 2 and a new deformation is caused.

Incidentally, the coupling should be made between the tire model 2 and snow model 6 which are at the same point in time.

The computing of deformation of the snow model 6, computing of deformation of the tire model 2 and the coupling of the tire model 2 and snow model 6 are repeated, while performing a decision of whether these should be repeated or stopped.

For example, the decision is whether the total simulation time has reached to the preset time (in case of the example shown in Fig.12) or whether the processing is interrupted by another factor, e.g. a manual operation and the like.

When the simulation is stopped, or during executing the simulation, the simulation data are outputted as graphics (still, animation), numeric list or table, and the like.

* Computing of Deformation of Tire model

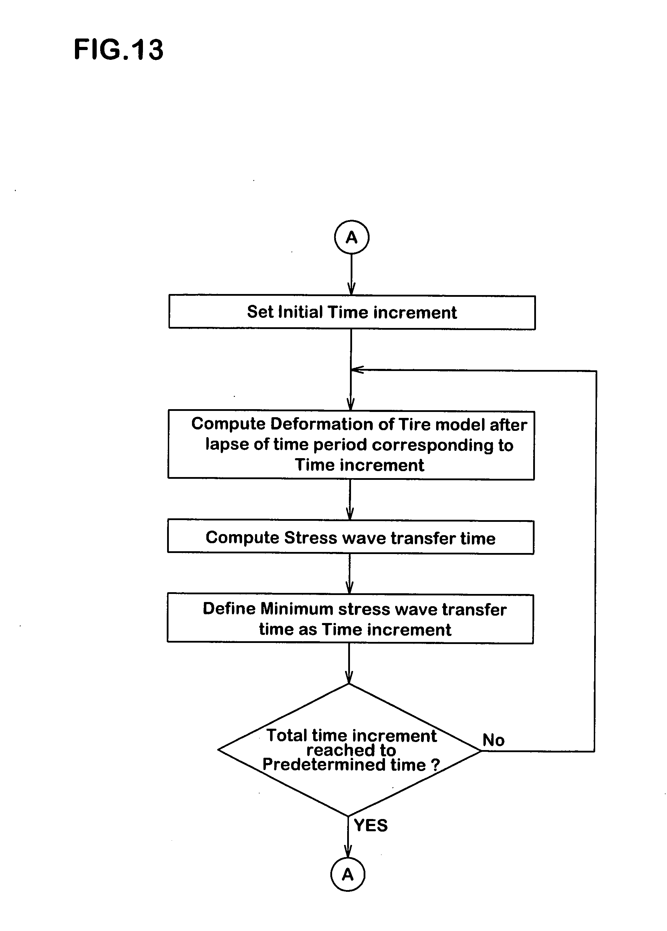

Fig.13 shows an example of the procedures for computing deformation of the tire model 2.

The deformation of each element occurring after the lapse of a time period corresponding to a time increment $\Delta t$ from a certain point of time is computed, using the following motion equation in a finite element method.

$$F = M\ddot{x} + C\dot{x} + Kx$$

where
F: External force matrix,
M: Mass matrix,
C: Damping matrix,
K: Stiffness matrix,
$x$: Displacement matrix,
$\dot{x}$: Velocity matrix,
$\ddot{x}$ : Acceleration matrix.

In this example, the boundary condition relating to the torque is changed every time period according to the predetermined rate as shown in Fig. 18 for example.

with respect to each of the elements after the lapse of the above-mentioned time period computed, the stress wave transfer time thereof is computed based on the size and mass density of the element because the stress wave transfer time is a function of the size and mass density and changes along with the deformation of the elements.

The minimum stress wave transfer time is. found out from all the elements to be computed, and the minimum time is defined as the time increment used in the next time computing of deformation. whether the total time increment has reached to the predetermined time or not is checked.

If not, the computing of deformation is again carried out based on the time increment newly defined as explained above. If having reached, the repetition of computing of deformation of the tire model based on the certain boundary conditions relating to the snow model is stopped to go to the next step.

* Computing of Deformation of Snow model

On the other hand, computing of deformation of the snow model 6 is carried out.

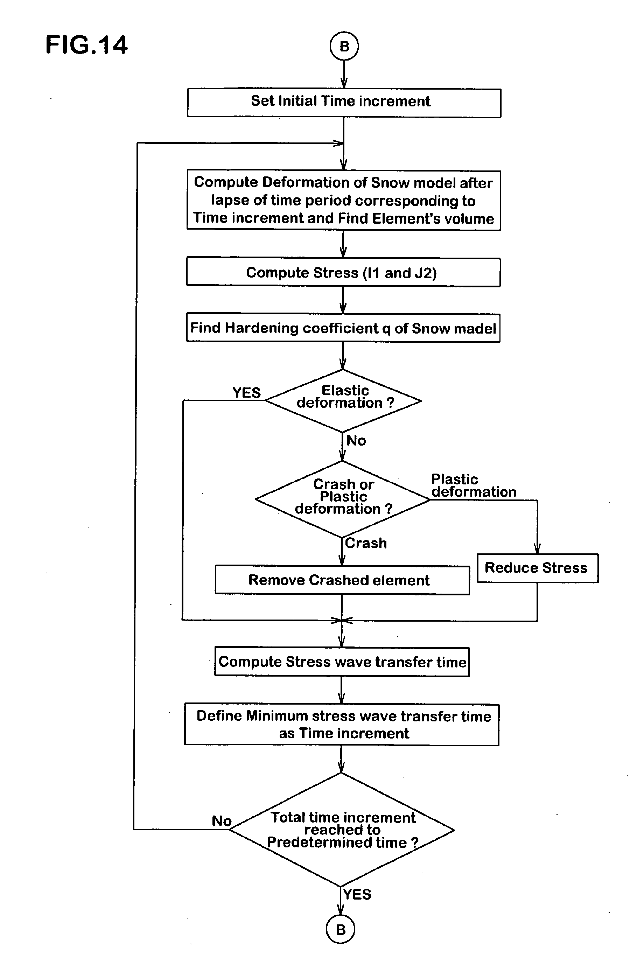

Fig.14 shows an example of the procedures therefor.

The deformation of each element of the snow model 6 after the lapse of a time period corresponding to a time increment from a certain point of time is computed.

To be more precise, based on the boundary conditions relating to the tire model, the pressure P applied to the snow model is computed, and the volume of each element is computed, using the following equation.

$$P = k \cdot \varepsilon$$

where
$k$: Modulus of volume elasticity,
$\varepsilon$ : volumetric strain.

with respect to each of the elements after the lapse of the above-mentioned time period computed, the first invariant $I_1$ of the stress and the second invariant $J_2$ of the deviatonic stress are computed.

The first invariant $I_1$ of the stress is defined by the sum of principal stresses $\sigma 1$, $\sigma 2$ and $\sigma 3$.

In connection with the X-Y-Z axes, the deviatonic stresses $\sigma x'$, $\sigma y'$ and $\sigma z'$ are respectively defined as the vertical stresses $\sigma x$, $\sigma y$ and $\sigma z$ from which the static pressure component $\sigma m$ is subtracted. Namely,

$$\sigma x' = \sigma x - \sigma m \, , \, \sigma y' = \sigma y - \sigma m \, , \, \sigma z' = \sigma z - \sigma m$$

where $\sigma m = (\sigma x + \sigma y + \sigma z)/3$ .

The second invariant $J_2$ of the deviatonic stresses is defined as

$$J_2 = \sigma x' \times \sigma y' + \sigma y' \times \sigma z' + \sigma z' \times \sigma x' - \tau xy2 - \tau yz2 - \tau zx2$$

where $\tau xy$, $\tau yz$ and $\tau zx$ are shear stresses.

The first invariant $I_1$ and second invariant $J_2$ are parameters of the undermentioned crash condition and yield condition.

* Hardening coefficient

Further, for each of the elements in the snow model 6, the hardening coefficient q is computed, using the following equations (1) and (2) obtained by experiments.

$$q = -\frac{1}{2a}\ln\left(1+\frac{\alpha}{b}\right) \qquad 0 \le -\alpha \le f \cdot b \qquad \text{--- Eq.(1)}$$

$$q = \frac{1}{2a}\left[\frac{-\alpha - fb}{b(1-f)} - \ln(1-f)\right] \qquad -\alpha > f \cdot b \qquad \text{--- Eq.(2)}$$

where

$\alpha$ : Volumetric plastic strain,

a and b: Experimental constants,

f: Value to prevent the value in parentheses (1-f) from becoming zero. "f" is near but smaller than 1.00. For example, a value in the range of from 0.90 to 0.99 is preferably used.

In this embodiment, in order to simulate new snow, the hardening coefficient q is defined by the two equations (1) and (2) so that the rate of hardening increases as the snow is compressed. But, needless to say, the hardening coefficient q can be defined differently, depending on the snow to be simulated. The hardening coefficient (q) is a parameter of the yield conditions for the elements of the snow model.

* Determination of the kind of deformation

For each of the elements of the snow model 6, whether the deformation computed reaches to the elastic deformation zone or not is determined by the yield conditions.

The yield condition is set using the above-mentioned first invariant $I_1$, second invariant $J_2$ and hardening coefficient q. To be more precise, the yield condition or yield surface of the snow model 6 is defined by the following equations (4).

$$f_c(I_1.J_2.q_c(\alpha_c)) = \sqrt{J_2 + \frac{c_c}{q_c}(\bar{I}_1 + q_c)^4} - k_c\bar{I}_1 - \sqrt{C_c q_c^{\,3}} \le 0$$

$$f_t(I_1, q_t(\alpha_t)) = \frac{I_1}{3} - q_t$$

$$\bar{I}_1 = T - I_1$$

where,

$I_1$ is the first invariant,

$J_2$ is the second invariant,

q is the hardening coefficient,

T is a parameter relating to the cohesive strength (cohesion) of snow and

k is a material parameter relating to the angle of friction.

The suffix "c" means "under compression", and

the suffix "t" means "under tension".

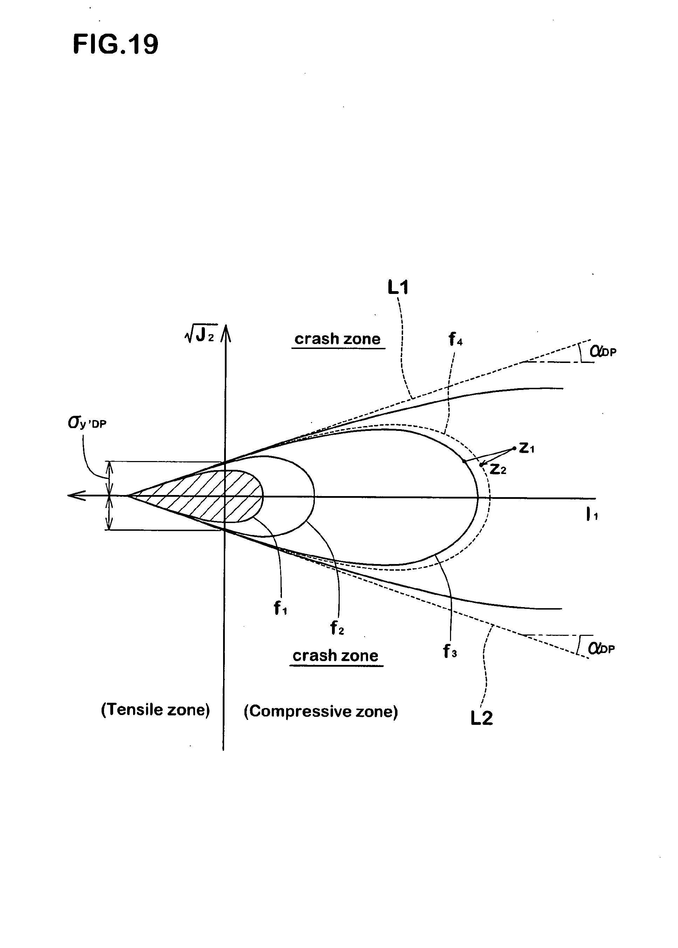

Thus, depending on the parameters $I_1$, $J_2$ and q, the yield condition of the snow model varies as shown in Fig.19.

In this graph, the vertical axis denotes the square root of the second invariant $J_2$ of the deviatonic stress of the snow model element, and the horizontal axis denotes the first invariant $I_1$ of the stress.

The yield condition describes a closed curve f (f1, f2, f3 --).

The inside of the closed curve f is an elastic deformation zone, and accordingly, the outside is the plastic deformation zone.

In case of yield condition f1, for example, the hatched area is the elastic deformation zone.

To each snow model element, one yield condition f is set, using the first invariant $I_1$, second invariant $J_2$, and hardening coefficient q in the equations (4) as explained above.

whether the coordinates determined by the first invariant $I_1$ and second invariant $J_2$ are in the above-mentioned yield condition f or not, namely, inside the closed curve f or outside is examined to determine whether the deformation computed is in the elastic deformation zone or not.

If the deformation is in the elastic deformation zone, the undermentioned stress reducing step is carried out.

when the deformation is outside the elastic deformation zone, there are two possible cases. One is that the element is crashed (crash zone). The other is that the element displays a plastic deformation without crashing (non-crash zone).

Therefore, whether the deformation is in the crash zone or non-crash plastic deformation zone is examined, using the crash condition given by the following equation (5)

$$f(I_1, J_2) = \sqrt{J_2} - \alpha_{DP} \cdot I_1 - \sigma_{y'DP} \qquad \text{Eq. (5)}$$

where

$\alpha_{DP}$ : Internal friction angle of snow model,

$\sigma_{y'DP}$: parameter relating to adhesion of snow.

This equation describes two straight lines L1 and L2 in the same graph shown in Fig.19 as indicated by broken line.

The two straight lines L1 and L2 intersect at one point on the horizontal axis, including the above-mentioned curve f between them, and divide the plastic deformation zone into

the non-crash zone between the straight lines L1 and L2 but outside of the curve f, and

the crash zone extending from the upper side of the straight line L1 to the lower side of the straight line L2.

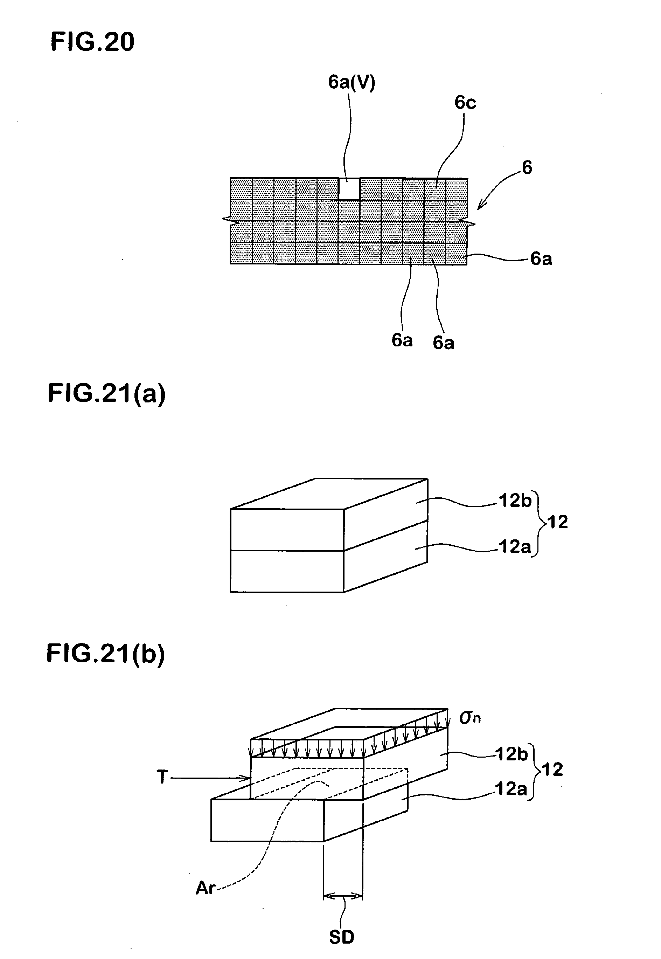

If in the crash zone, the crashed element is removed. In this example, as shown in Fig.20, the filler 6c in the crashed element 6a is deleted, and a void V is set instead.

If in the non-crash plastic deformation zone, the stress is reduced to a value in the elastic limit which the element is able to endure in order to stabilize the subsequent computation.

In case of the elastic deformation, as the strain is almost proportional to the stress, the computed results relating to the stressed object may be stable. But, in case of the plastic deformation, the results are liable to become unstable.

To be more precise, as shown in Fig.19 for example, when the yield condition is f3 and the stressed condition is Z1 in a step (t) and the yield condition is f4 in the next step (t+1), in order to reduce the stress, the stressed condition is returned to a value Z2 on the yield condition f4.

In order to return the stressed condition, for example, a radial return method is preferably employed.

By reducing the stress as above, the computing of plastic deformation becomes stable, and it becomes possible to simulate the trodden or packed snow with more accuracy.

In connection with the equation (5), the internal friction angle $\alpha_{DP}$ of the snow and the parameter $\sigma_{y'DP}$ relating to adhesion are determined, based on experimental values.

Fig.21(a) shows a method of measuring the shearing stress and strain of a snow rod using a piping 12, the piping 12 divided by a cut into an upper part 12a and a lower part 12 b.

The snow rod is formed by filling the piping with packed snow, and as shown in Fig.21(b) while giving a vertical stress $\sigma n$ and a shearing force T, the shear displacement SD is measured. The shearing stress $\tau t$ is obtained by dividing the shearing force T by the contacting area Ar between the upper part 12b and lower box 12a.

$$(\tau t = T/Ar)$$

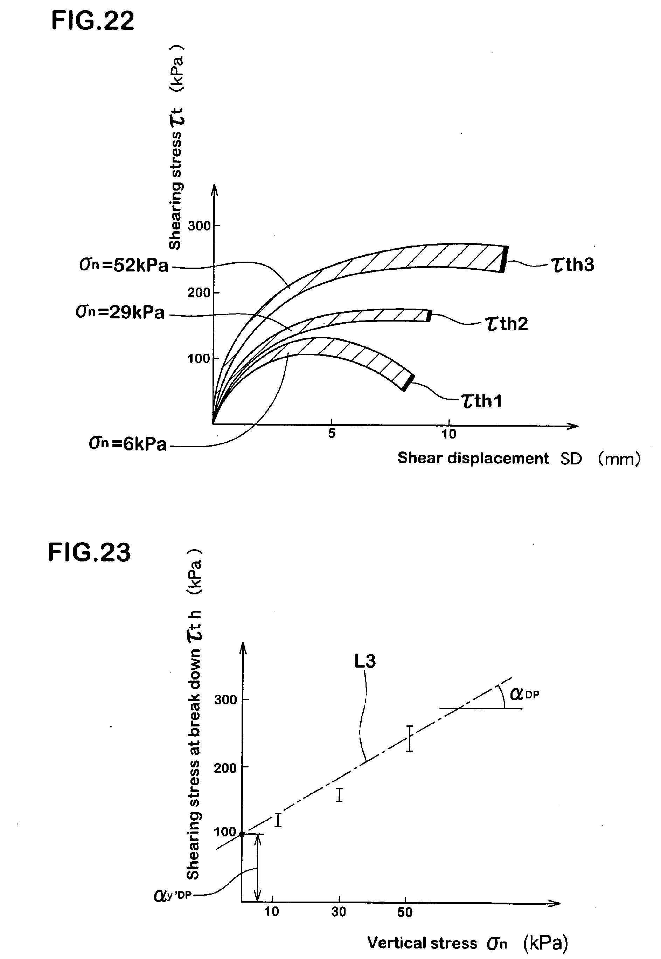

In Fig.22, the shearing stress $\tau t$ given and the shear displacement SD measured are plotted on various snow. From this result, the stress $\tau th1$, $\tau th2$, $\tau th3$ at which the snow rod is broken down can be determined for various snow conditions.

Fig.23 shows a regression straight line L3 showing the relationship between the vertical stress $\sigma n$ and the shearing stress $\tau th$ at break down which was obtained from the experimental values. It is preferable that the inclination of the regression straight line L3 is defined as the internal friction angle $\alpha_{DP}$ of the snow, and the shearing stress $\tau th$ at break down under the vertical stress $\sigma n$ of 0 is defined as a parameter $\alpha_{y'DP}$ relating to adhesion. Here, the parameter $\alpha_{y'DP}$ relating to adhesion means the shearing stress at which shear fracture occurs under such a state that the vertical stress $\sigma n$ is not applied.

* Computing of stress wave transfer time

In the same way as in the tire model 2, with respect to each of the elements of the snow model 6 after the lapse of the above-mentioned time period computed, the stress wave transfer time thereof is computed.

Then, from all the elements to be computed, the minimum stress wave transfer time is found out.
The minimum time is defined as the time increment used in the next computing of deformation.

Whether the total time increment has reached to the predetermined time or not is checked.
If not, the computing of deformation is again carried out based on the time increment newly defined as explained above.
If having reached, the repetition of computing of deformation of the snow model 6 based on the certain boundary conditions relating to the tire model is stopped to go to the next step.

* Lagrange element

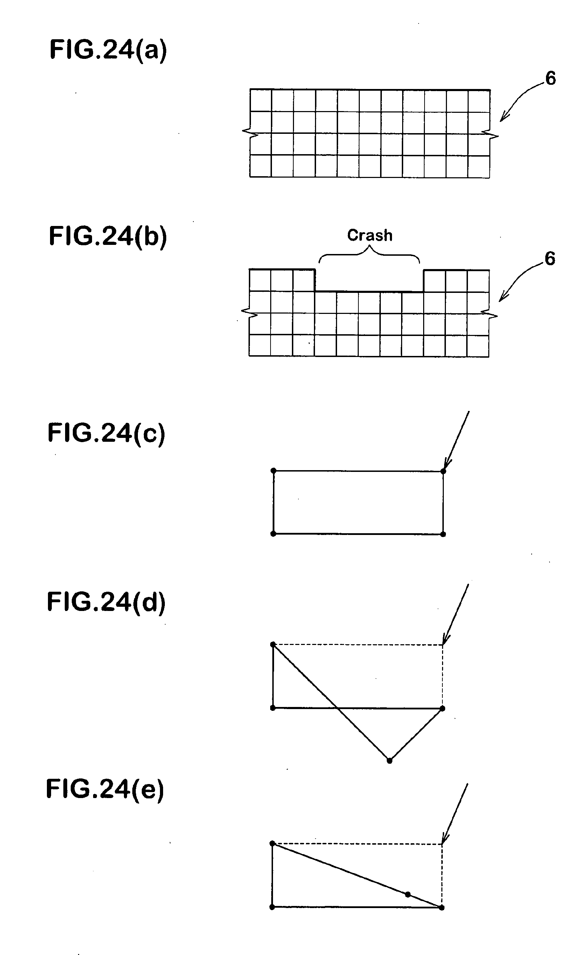

Aside from the Euler elements, Lagrange elements may be used in making the snow model 6. In case of the Lagrange element, if the deformation computed is in the crash zone, as shown in Figs.24(a) and 24(b), the crashed elements are removed. Then, the updated contacting conditions between the Lagrange elements newly forming the surface of the snow model and the elements of the tire model are defined. Specifically, the surface shape of the snow model 6 from which the crashed elements are removed is computed, and these date are set to the tire model 2 as the updated boundary conditions.

when the deformation of a Lagrange element is large, the volume of the element becomes negative as shown in Figs.24(c) and 24(d), namely, the element is destroyed, and the computing becomes impossible. Therefore, to prevent this, when the deformation is large, as shown in Fig.24(e) for example, the following conditions are preferably set. (1) The node points are limited not to cross the sides of the element. (2) The element is forcedly deformed into a state like a membrane element and only the force is transmitted to the next elements. whereby even in the Lagrange element model, it becomes possible to simulate the characteristics of snow.

The difference in the snow quality such as wet snow, dry snow, packed snow and new snow, can be simulated by changing the modulus of volume elasticity of the snow element, the frictional coefficient and the like.

* Outputting of Simulation Data

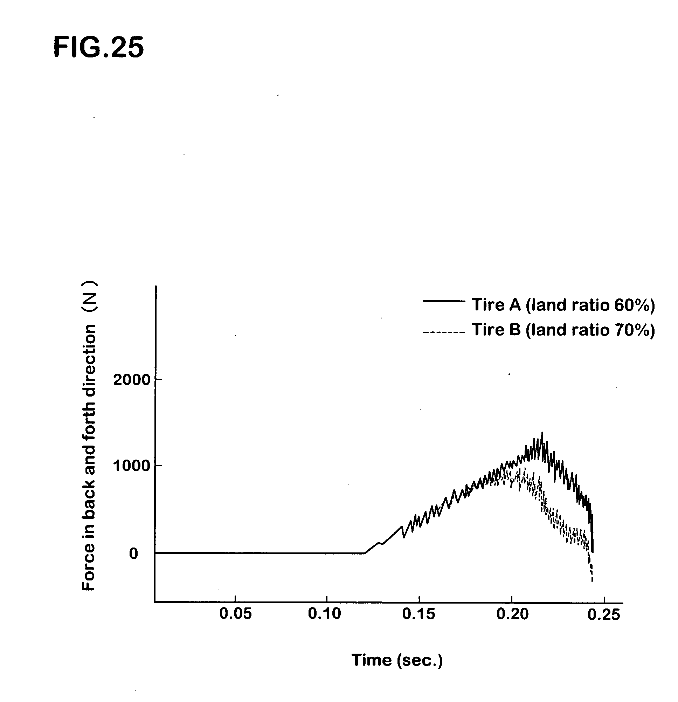

Fig. 25 is a computer output graph showing a force variation in the back and forth direction observed on the tire rotational axis CL through the simulation carried out by the method shown in Fig.17.
The force variation in the back and forth direction (in this case, traction force) can be computed as the horizontal component of the force generated between the tire model 2 and snow model 6. Form this graph, it is possible to estimate the traction performance of the tire as follows.
At first, as the tread face of the tire model 2 is pressed onto the snow model 6 by the vertical tire load, the snow model 6 is packed and hardened and it engages with the tread pattern comprising tread grooves GY.
when the torque Tr applied to the tire model 2 is small, as the packed hardened snow model 6 can resist to the shearing force, the traction force Ff increases in proportion to the increase in the torque Tr. However, when the torque Tr is increased up to a point, as the shear fracture is caused on the snow model elements engaging with the tread pattern, the traction force Ff gradually decreases. In Tire B having a larger land ratio (positive ratio) of 70%, when compared with Tire A having a land ratio of 60%, the peak value of the traction force became smaller and the decrease in the traction force starts earlier. The results well simulate the actual tires.

* Another Combination of Tire model and Road model

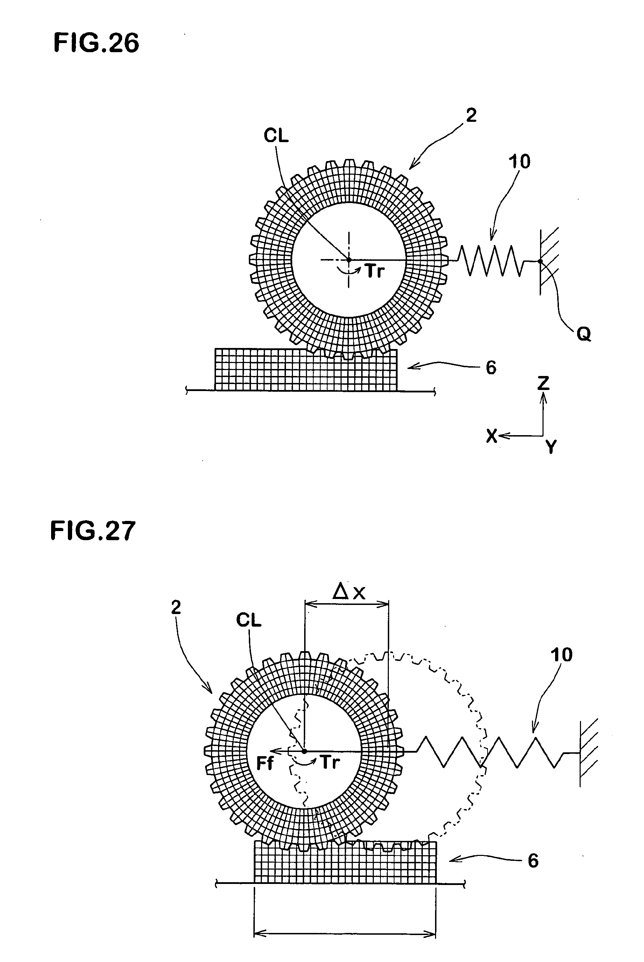

Fig.26 and Fig.27 show another way of defining the boundary conditions between the tire model and road model. In this example, like in the former example, the position of the snow model 6 is defined as being fixed in the X-Y-Z coordinate system. But, the tire rotational axis CL is defined as being movable in both of the vertical and horizontal directions, and to limit the horizontal motion of the tire model within a short traveling distance, the rotational axis CL is connected to one end of an elastic body model 10 of which other end is fixed to a fixed point Q in the coordinate system, while keeping the rotational axis CL horizontal.

The elastic body model 10 comprises spring elements which displays an elastic deformation when an external force is applied, and when a force Ff in the back and forth direction is generated on the tire model 2 and the elastic body model 10 is subjected to a tensile force, as shown in Fig.27, an displacement $\Delta x$ proportional to the force Ff occurs. Therefore, when the force Ff is increased, a skid occurs between the tire model 2 and snow model 6, and the traction force becomes decreases to zero. The displacement $\Delta x$ can be computed from the force Ff computed and the spring constant K preset to the elastic body model 10.

Under such conditions, the vertical tire load Fp and the gradually increasing torque Tr are defined in the same way as in the former example.

In this example, therefore, the tire model 2 can roll on for a limited distance, contrary to the former example. Thus, it is possible to simulate a rut on the snow and analyze the pressure distribution and the like.

In the above-mentioned two examples of the combinations of the tire model and snowy road model, the road model is defined as being immovable with respect to the coordinate system.

However, it is also possible to define the road model as being movable in the back and forth direction, while the tire model 2 is defined as being immovable in the back and forth direction. of course the tire model is defined as being rotatable around its rotational axis CL and as being movable in the vertical direction.

Further, according to need, the tire model can be defined as being rotatable around a vertical axis.

In this case, a definite length is defined in the snow model 6, and as the road model moves, the snow elements are deleted at the front end of the road model and new elements are added at the rear end like a moving walk or belt conveyor.

Such a movable road model is suitably used to simulate cornering tire performance on snow by defining a slip angle.

In the above-mentioned examples the tire model 2 contacts with the snow model 6 from the initial stage of the simulation.

But it is also possible to define the boundary conditions such that the tire model 2 is initially apart from the snow model 6, and then they are gradually contact each other.

Further, the following simulation may be effectual for evaluating the breaking performance on snow. By contacting a tire model which is rotating by its inertia above the snow model, with the surface of the snow model with a certain vertical tire load, the force in the back and forth direction produced between the tire model and show model with time is computed until the rotation is stopped due to the friction, sharing resistance and the like.

* Data showing Tire Performance

In order to evaluate tire performance, the data relating to the snow model 6 obtained through the computation of deformation, e.g. the mass density, pressure, stress, velocity and contact force and the like can be used. of course it is also possible to obtain tire performance data from the tire model.

Data, for example the value of mass density, of each element obtained through the computing of deformation, are compared with the predetermined data, for example threshold values, and rounded off into the predetermined number of levels.

The rounded data are visualized by assigning different colors corresponding to the levels and overlapping a view of the model.

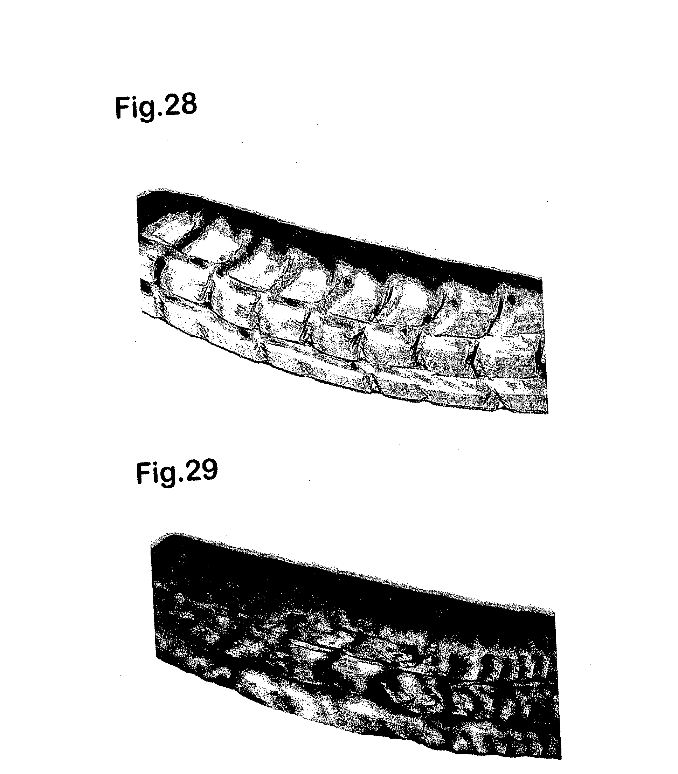

Fig.28 is a simulation output which visualizes a rutted snow where no tire skid occurs. This view is a perspective from the underside of the tire tread showing the surface of the snow.

Fig.29 is a similar view where a skid occurs a little bit and as a result, the impression of the tread pattern begins to crumble away.

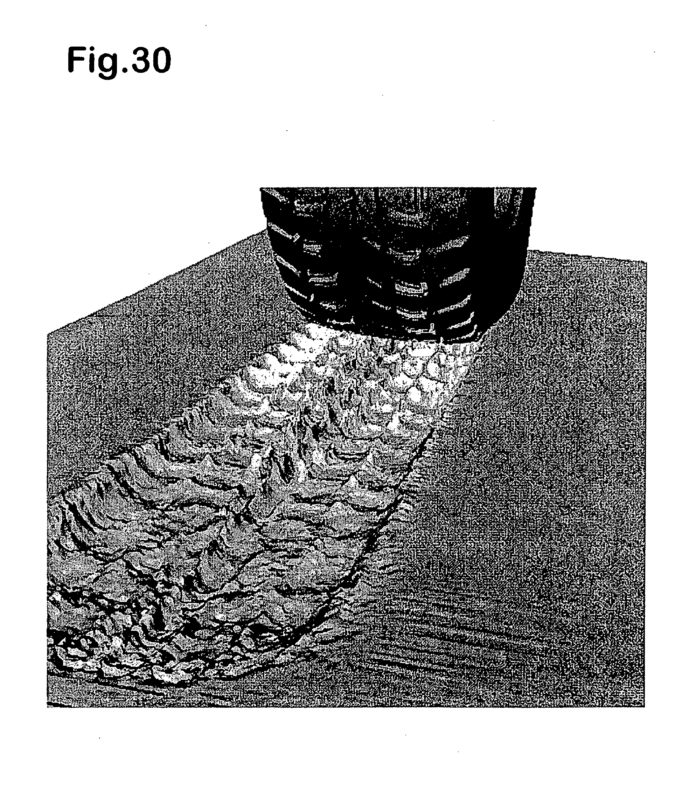

Fig. 30 is a simulation output which visualizes the tire and rutted snow as a perspective view, where the rut is well reproduced with reality.

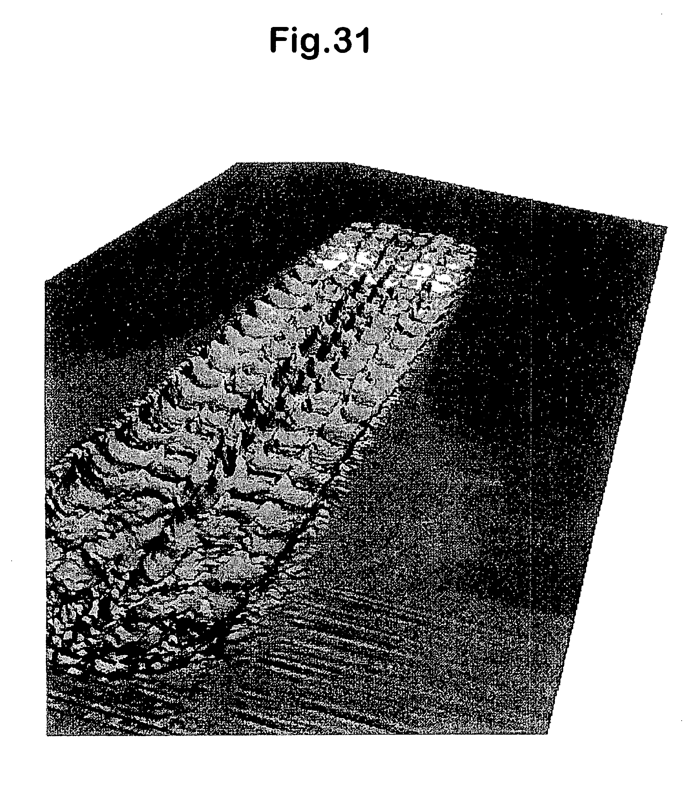

Fig. 31 is a simulation output which visualizes a rut on the snow as a perspective view, together with a ground pressure distribution which is indicated by a change of color in actuality although this figure is indicated in monochrome.

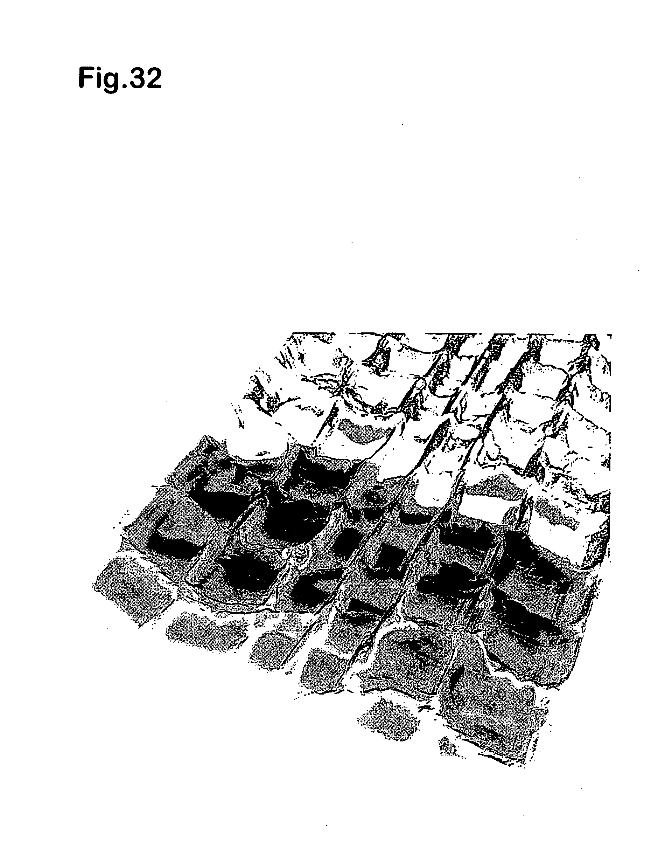

Fig.32 shows an enlarged view similar to Fig. 31 indicating the ground pressure distribution in a gray scale instead of the change of color, where the darker the color, the higher the pressure.

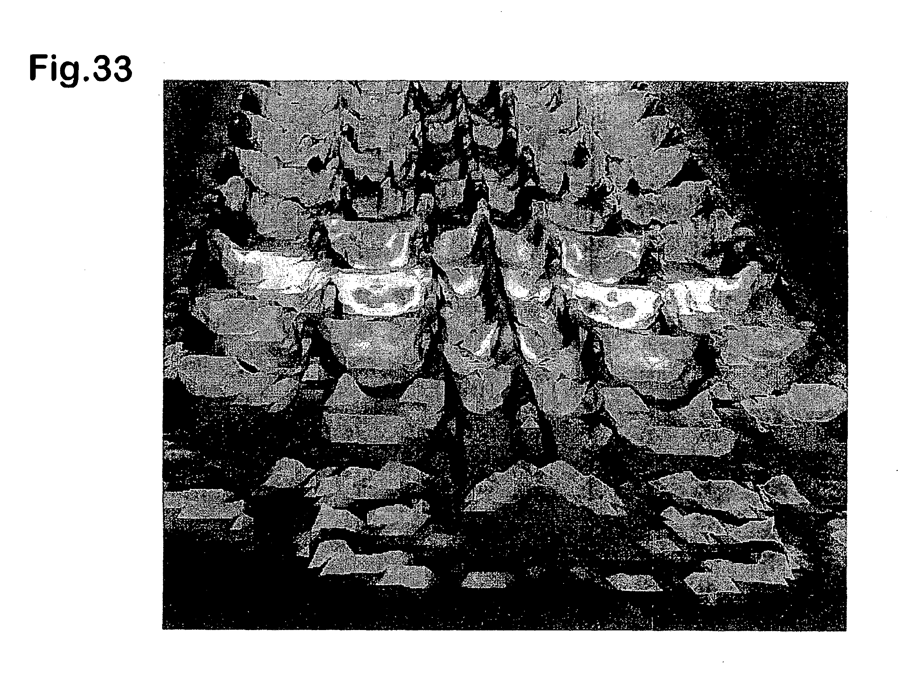

Fig.33 is a simulation output which visualizes a rut on the snow as a perspective-view, together with a distribution of mass density of the trodden snow which distribution is indicated by a change of color in actuality although this figure is indicated in monochrome.

The mass density of an element is the mass of the snow in the element divided by the volume of the element, and

the mass is obtained by computing the difference (m1-m2) between the total inflow mass m1 and total outflow mass m2 of the element.

when the mass density of the snow model element becomes higher, the element becomes harder, and a trodden part of the snow having a higher mass density exhibits a larger shearing force.

On the other hand, the traction force and braking force of the tire on a snowy road are mainly produced by the shearing force of the snow compressed and pushed into the tread grooves, and the scratch force generating when the snowy road surface is scratched with the edges of the tread grooves and sipes if any.

If the snow has a high mass density distribution in its part engaging with the tread grooves, the tire will show a large traction/braking force. Therefore, the mass density distribution can be used as a judgmental standard for the traction and braking performance of the tire.

when the groove/sipe edges are generating a scratch force, the relevant part of the snowy road surface shows a higher ground pressure. Therefore, the ground pressure distribution can be also used as a judgmental standard for the traction and braking performance of the tire, especially for the estimation of the edge effect.

In case of Fig.33 or corresponding tread pattern, it can be seen that the mass density becomes high in the center (highlight part) of the ground contacting patch with respect to the tire circumferential direction and axial direction.

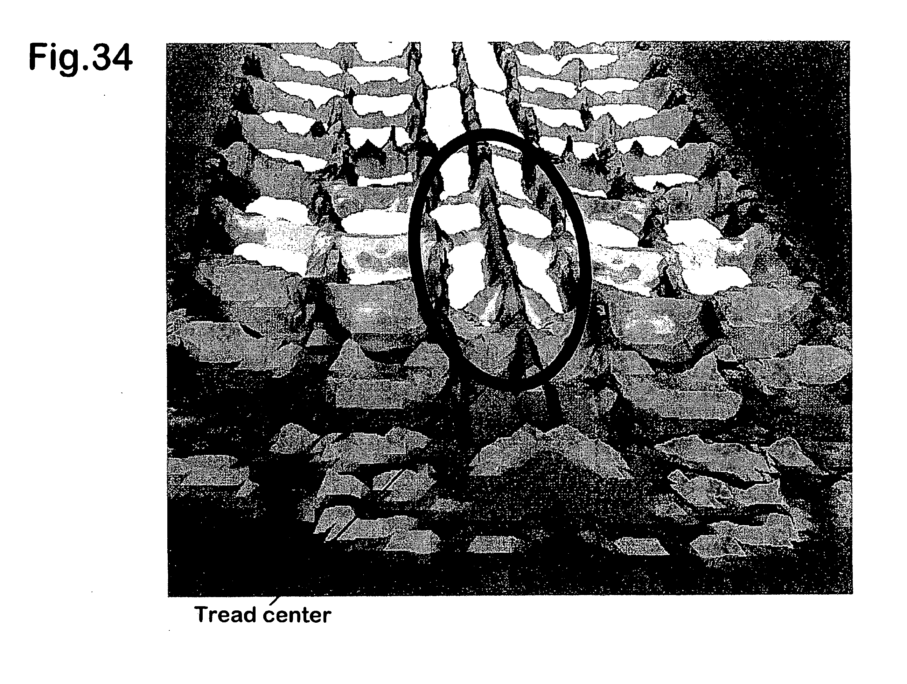

Fig.34 shows the same data as used in Fig.33 but in a different way such that the under part from a certain snow depth is hidden to improve the visibility of the snow compressed and pushed into the tread grooves.

To be concrete, in this example as the z-axis corresponds to the snow depth, only the elements whose z-coordinate value is larger than a certain value (over 5 mm from the bottom of the show model) are visualized in the same way as Fig.33.

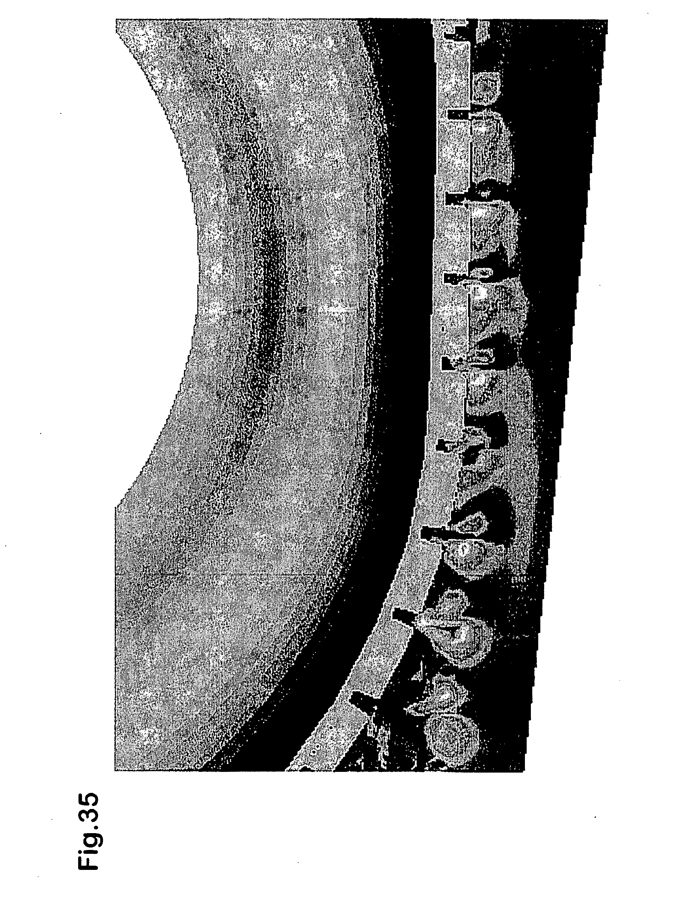

Fig.35 is a simulation output which visualizes a distribution of the shearing stress of the snow model 6 in a part contacting with the tire model, wherein the distribution is indicated by a change of color in actuality although this figure is indicated in monochrome. From this figure it can be seen that the shearing stress becomes large at the groove edges.

* Others

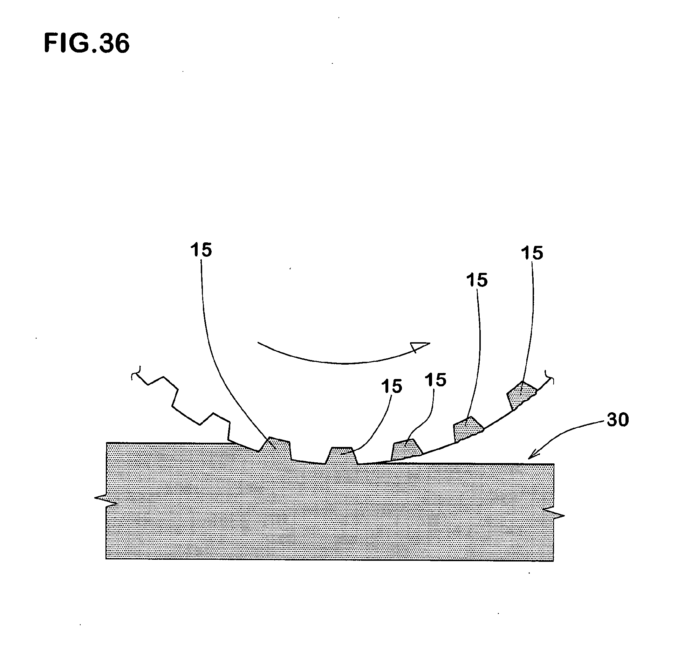

If there are crashed snow elements, the crashed elements are deleted to separate the noncrashed elements on one side of the crashed elements from the noncrashed elements on the other side. As a result, as shown in Fig. 36, it becomes possible to simulate the tire which shear the snow rods 15 packed into tread grooves and the tire whose tread grooves are embedded in snow. This is especially effectual for cornering simulation at a large slip angle and starting and braking simulation accompanying tire slip.

* Snow velocity

The above-mentioned velocity of the snow model 6 means the speed of the deformation or strain of the snow caused by the tire tread when the tire is rolling on the snowy road.

with regard to a snow model element, the deformation speed can be defined by a traveling speed of the snow in the element, an inflow speed of snow into the element, or an outflow speed of the snow from the element, each computed during simulation. Further, the strain speed can be obtained by the following

$$\text{Strain speed} = (\rho' - \rho)/(t' - t)$$

where

$\rho$ and $\rho'$ are the mass densities of the element,

$t$ and $t'$ are the times,

Single quote indicates that of the element after deformed.

Here, the strain speed is the transmission speed of the deformation, and as the medium is snow, the strain is treated as a compressive strain.

* Contact force

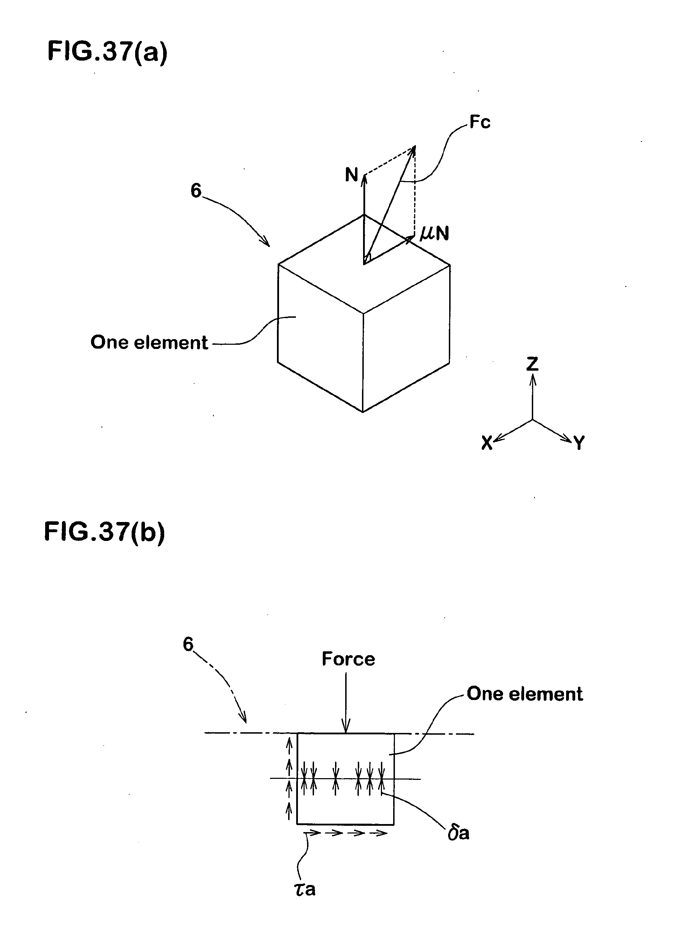

The above-mentioned contact force is the contact force Fc between the snow model and tire model which is as shown in Fig.37(a) the vectorial sum Fc of the frictional force µN therebetween and the vertical force N. By making a vector resolution of the contact force Fc about the XYZ axes, namely, into the three directions of the force in the back and forth direction, side force and vertical force, the these forces can be obtained. For example, the force in the back and forth direction can be used to evaluate the traction force and braking force on snow.

AS to the stress which is produced on a snow element by the tire model 2, as shown in Fig.37(b), the vertical component $\sigma a$ thereof may be treated like the above-mentioned ground pressure. As a result, the above-mentioned edge effect can be estimated therefrom. As to the shearing stress $\tau a$, by setting the direction thereof in parallel with the back and forth direction, the snow rod shearing force $\tau$ may be directly estimated.

As to the above-mentioned mass density of the snow model 6, as a measure to reduce the computer burden, it is possible to compute only the elements which contact with the tire model 2, and on the assumption that the mass density decreases in proportion to the depth from the surface, a certain value is defined accordingly as the mass density of the inside elements without computing.

* Making of Prototype and Manufacturing of Tire

According to the results of a simulation, one or more parameters such as tread pattern, tread rubber material, tread profile, tire internal structure, groove/sipe shape, groove/sipe depth, and groove/sipe width are changed, and again a simulation is carried out. Such desk work is repeated until a satisfactory result can be obtained. when obtained, a prototype is made, and performance test is carried out using an actual test car. If again a satisfactory result can be obtained, the tires are manufactured. If the difference between the simulation result and experimental results is not negligible, corrections are made on the simulation software.

**Claims**

1. A method of simulating a tire on snow comprising
    making a model of the tire made up of numerically analyzable elements,
    making a model of the snow made up of numerically analyzable elements being capable of presenting its volume change caused by compression and being capable of maintaining a volume change after the compression is removed,
    repeating: setting of conditions for rolling the tire model and contacting the tire model with the snow model; computing of deformation of the tire model; and computing of deformation of the snow model, at minute time intervals to obtain at least one of the following data: a force produced on the tire model in the back and forth direction; mass density, pressure, stress, and velocity of the snow model; and contact force between the tire model and snow model, and
    outputting said at least one of the data.

2. The method according to claim 1, wherein
    the method further comprises
    defining the tire model as being rotatable around its rotational axis and being movable only in the vertical direction in relation to a coordinate system, and
    defining the snow model as being immobilize in relation to said coordinate system, and
    said conditions including a torque applied to the tire.

3. The method according to claim 1, wherein
    the method further comprises
    defining the snow model as being immobilize in relation to a coordinate system,
    defining the tire model as being rotatable around its rotational axis, and
    defining a model of an elastic body of which one end is fixed in relation to the coordinate system and the other end is connected to the rotational axis, and
    said conditions including a torque applied to the rotational axis of the tire.

4. The method according to claim 1, 2 or 3, wherein
    the tire model is of a halved tire on one side of the tire equator.

5. The method according to claim 1, 2, 3 or 4, wherein
    said outputting includes outputting one of the data by visualizing the distribution thereof in gray scale or changing color.

6. The method according to claim 1, 2, 3 or 4, wherein
said outputting includes outputting one of the data relating to the snow model by visualizing the distribution thereof in gray scale or changing, color and overlapping a view of the snow model.

7. The method according to claim 1, 2, 3 or 4, which further comprises
visualizing and outputting specific elements which have data included in a predetermined specific range.

# FIG.1

```
        ╭─────────────────────╮
        │   Simulating Tire   │
        ╰─────────────────────╯
                   │
                   ▼
    ┌───────────────────────────────┐
    │  Make Tire model and Road mode │
    └───────────────────────────────┘
                   │
                   ▼
    ┌───────────────────────────────┐
    │     Set Boundary conditions    │
    └───────────────────────────────┘
                   │
                   ▼
    ┌───────────────────────────────┐
    │ Compute Deformation of Tire model │
    │  and Road model after minute time │
    └───────────────────────────────┘
                   │
                   ▼
    ┌───────────────────────────────┐
    │ Couple Tire model and Road model │
    │        with each other          │
    └───────────────────────────────┘
                   │
                   ▼
             ╱╲
            ╱  ╲     No (Repeat)
           ╱Repetition╲ ──────────►
           ╲  end ?  ╱
            ╲  ╱
             ╲╱
             │ YES
             ▼
    ┌───────────────────────────────┐
    │    Output Data for evaluation   │
    └───────────────────────────────┘
                   │
                   ▼
        ╭─────────────────────╮
        │  End of Simulation  │
        ╰─────────────────────╯
```

## Fig.2

2
2a
2b
2c

## Fig.3

2(2H)
2a
2b
2c

# FIG.4

# FIG.5

(c1)c

t

f { t
    c

5c ⎫
5a
5d ⎬ 5
5b
5e ⎭

# Fig.6

EP 1 380 972 A2

**FIG.7**

**FIG.8**

**FIG.9**

**FIG.10**

# FIG.11

# FIG.12

```
                    ( Simulating Tire on Snow )
                              │
                              ▼
                    ┌──────────────────────┐
                    │    Make Tire model    │
                    └──────────────────────┘
                              │
                              ▼
                    ┌──────────────────────┐
                    │  Make Snowy road model│
                    └──────────────────────┘
                              │
                              ▼
                    ┌──────────────────────┐
                    │ Set Boundary conditions│
                    └──────────────────────┘
                              │
                              ▼
   ┌────────────────────────────────────────────────────────────┐
   │  ◁ A  ┌────────────────────┐  ┌────────────────────┐  B ▷   │
   │       │ Compute Deformation│  │ Compute Deformation│        │
   │       │   of Tire model    │  │   of Snow model    │        │
   │       └────────────────────┘  └────────────────────┘        │
   │                          │                                   │
   │                          ▼                                   │
   │                    ◇ Repetition ◇  YES  → ( 1 )              │
   │                    ◇  end ?    ◇                             │
   │                          │                                   │
   │                     No (Repeat)                              │
   │                          ▼                                   │
   │  ┌────────────────────┐     ┌────────────────────┐          │
   │  │ Set Data obtained by│     │ Set Data obtained by│         │
   │  │ computing Deformation│    │ computing Deformation│        │
   │  │   of Snow model      │    │   of Tire model      │        │
   │  │  as New boundary     │    │  as New boundary     │        │
   │  │   conditions for     │    │   conditions for     │        │
   │  │ computing Deformation│    │ computing Deformation│        │
   │  │   of Tire model      │    │   of Snow model      │        │
   │  └────────────────────┘     └────────────────────┘          │
   └────────────────────────────────────────────────────────────┘
                              ( 1 )
                              │
                              ▼
                    ┌──────────────────────┐
                    │ Output Data for evaluation│
                    └──────────────────────┘
                              │
                              ▼
                    ┌──────────────────────────────┐
                    │ Estimate Tire performance on Snow│
                    └──────────────────────────────┘
                              │
                              ▼
                          ( End )
```

# FIG.13

A

Set Initial Time increment

Compute Deformation of Tire model after lapse of time period corresponding to Time increment

Compute Stress wave transfer time

Define Minimum stress wave transfer time as Time increment

Total time increment reached to Predetermined time ?

No

YES

A

## FIG.14

(B)

Set Initial Time increment

Compute Deformation of Snow model after lapse of time period corresponding to Time increment and Find Element's volume

Compute Stress (I1 and J2)

Find Hardening coefficient q of Snow madel

Elastic deformation ? — YES

No

Crash or Plastic deformation ? — Plastic deformation

Crash

Remove Crashed element

Reduce Stress

Compute Stress wave transfer time

Define Minimum stress wave transfer time as Time increment

Total time increment reached to Predetermined time ? — No

YES

(B)

# FIG.15

# FIG.16

Tire rolling direction

# FIG.17

# FIG.18

# FIG.19

**FIG.20**

6a(V)

6c

6

6a

6a    6a

**FIG.21(a)**

12b
12
12a

**FIG.21(b)**

$\sigma_n$

T

12b
12
12a

Ar

SD

**FIG.22**

**FIG.23**

EP 1 380 972 A2

FIG.24(a)

6

FIG.24(b)

Crash

6

FIG.24(c)

FIG.24(d)

FIG.24(e)

31

# FIG.25

## FIG.26

## FIG.27

Fig.28

Fig.29

# Fig.30

# Fig.31

**Fig.32**

Fig.33

Fig.34

Tread center

Fig.35

**FIG.36**

## FIG.37(a)

## FIG.37(b)

**FIG.38**